Europäisches Patentamt

European Patent Office

Office européen des brevets

(11) Numéro de publication : **0 558 418 A1**

# (12) DEMANDE DE BREVET EUROPEEN

(21) Numéro de dépôt : 93400486.2

(22) Date de dépôt : 25.02.93

(51) Int. Cl.⁵ : **G11C 11/22,** G11C 27/00

(30) Priorité : 27.02.92 FR 9202304

(43) Date de publication de la demande :
01.09.93 Bulletin 93/35

(84) Etats contractants désignés :
**DE GB IT NL**

(71) Demandeur : **COMMISSARIAT A L'ENERGIE ATOMIQUE**
**31-33, rue de la Fédération**
**F-75015 Paris (FR)**

(72) Inventeur : **Achard, Hervé**
**1, place Doyen Gosse**
**F-38000 Grenoble (FR)**
Inventeur : **Joly, Jean-Pierre**
**22, place Salvador Allende**
**F-38120 Saint-Egreve (FR)**

(74) Mandataire : **Mongrédien, André et al**
**c/o BREVATOME 25, rue de Ponthieu**
**F-75008 Paris (FR)**

(54) **Cellule mémoire non volatile du type métal-ferroélectrique semi-conducteur.**

(57) L'invention concerne une cellule mémoire non volatile avec au moins un transistor métal-ferroélectrique-semi-conducteur comprenant une source (5), un drain (6) et une grille (4), la grille étant isolée de la source et du drain par une couche ferroélectrique (2). Les transistors d'une telle cellule mémoire comportent chacun une électrode latérale de programmation (BL) en contact avec une paroi verticale de la couche ferroélectrique et isolée de la grille et ils comportent aussi, de façon avantageuse, une couche diélectrique (7) entre les couches ferroélectrique et semi-conductrice (1).
Application aux mémoires statiques.

FIG. 3 B

EP 0 558 418 A1

Jouve, 18, rue Saint-Denis, 75001 PARIS

L'invention concerne une cellule mémoire non volatile du type métal-ferroélectrique-semi-conducteur et une mémoire comportant de telles cellules mémoires.

Les mémoires à semi-conducteurs actuelles se répartissent en deux catégories selon que l'information stockée disparaît ou non lorsque l'alimentation en énergie de la mémoire est coupée. Ces mémoires sont répertoriées sous deux appellations distinctes. On trouve les mémoires volatiles (appelées aussi mémoires dynamiques) et les mémoires non volatiles (appelées également mémoires statiques).

Les mémoires non volatiles sont, dans beaucoup de cas, des mémoires lues uniquement ("read only memory", en terminologie anglosaxonne). Dans ces mémoires, l'information est stockée une fois pour toutes et ne peut pas être modifiée. En réalité, il existe, parmi ces mémoires à lecture uniquement, les mémoires PROM ("programmable read - only memory", en termes anglosaxons) ainsi que les mémoires EEPROM ("Electrically erasable programmable read - only memory", en termes anglosaxons) pour lesquelles on peut modifier l'état de l'information, mais ceci un nombre limité de fois, cette opération de modification de l'information étant longue.

Ces mémoires sont donc utilisées, en général, dans certaines applications telles que le stockage des programmes systèmes dans les ordinateurs.

Dans toutes les autres applications, on utilise des mémoires dynamiques, c'est-à-dire volatiles.

Les mémoires à semi-conducteurs non volatiles, existant sur le marché actuellement, utilisent essentiellement le principe du stockage de charge par injection de porteurs (électrons ou trous) dans un diélectrique. Ces charges sont stockées soit dans une électrode conductrice noyée dans des diélectriques (électrodes flottantes, structures SAMOS, FLOTOX), soit à une interface entre deux diélectriques (structure MIOS). De telles mémoires non volatiles sont décrites dans les pages 496 à 506 de la deuxième édition de la publication "Physics of Semi-conductors Device", rédigé sous la plume de S. H. SZE, et dans le chapitre intitulé "VLSI Electrically Erasable Programmable Read only memory", du document "VLSI Handbook", écrit sous la plume de S. K. LAY et V. K. DHAM et publié en 1985 par Academic Press.

L'état de la charge stockée détermine l'état binaire 0 ou 1 de l'information stockée dans le point mémoire individuel. L'information, donc la charge, est ensuite lue par l'effet de champ créé dans le semi-conducteur sous-jacent. La mise en inversion, ou accumulation de la zone de surface du semi-conducteur rend passant ou non passant un dispositif de type MOS dont l'électrode de grille est placée au-dessus de la zone où les charges sont stockées.

Le principe de l'écriture de l'information dans ces mémoires nécessite donc l'injection de porteurs dans un diélectrique. Cependant quelque soit le mode d'injection des porteurs, le processus d'accumulation de charge est lent. Un cycle d'écriture ou d'effacement a un temps supérieur ou égal à environ 10 microsecondes. De plus, l'injection créé des dommages irréversibles dans le diélectrique, sous forme de charges piégées écrantant peu à peu la charge stockée et limitant, ainsi, le nombre de cycles à un nombre inférieur à $10^6$, et ce dans le meilleur des cas. Le second document cité précédemment ("VLSI Hanbook") décrit de façon relativement précise cette injection de porteurs dans un diélectrique.

Enfin, les mémoires actuelles à faible coût et à forte densité "EPROM" ne sont pas effaçables électriquement et les "Flash EEPROM" ne peuvent être effacés que par bloc uniquement. Pour pallier un certain nombre de ces inconvénients, une nouvelle technologie a été proposée récemment. Cette technologie utilise les effets ferroélectriques. Elle est basée sur l'utilisation de condensateurs métal-ferroélectrique-métal pour stocker l'information. Le document, intitulé " A new memory technology is about to hit the market", de la Revue Electronics du 18 février 1988, décrit cette nouvelle technologie. Dans sa version la plus simple, on associe à un transistor conventionnel, un condensateur du type précité, selon le schéma électronique de la figure 2A représentant une cellule nommée cellule FRAM.

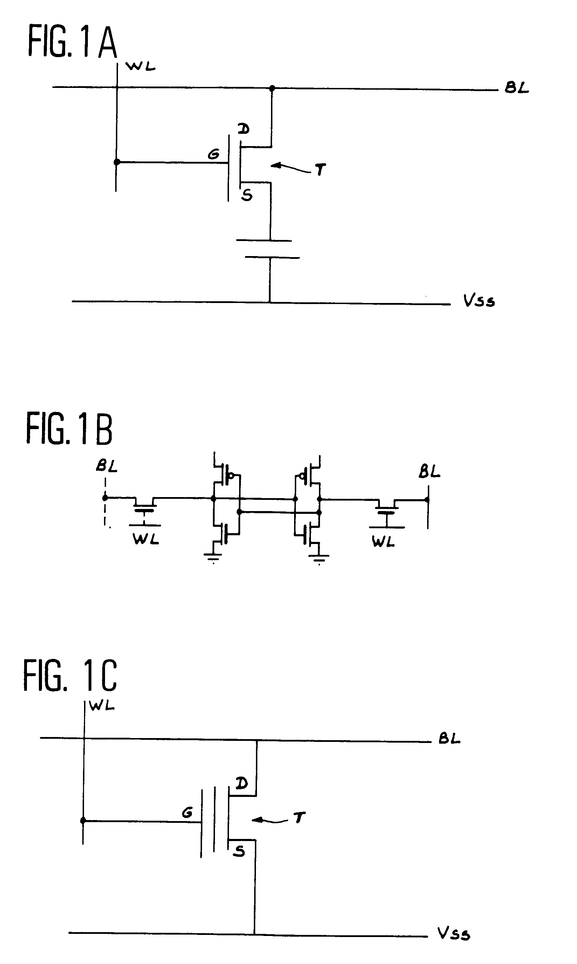

La programmation et la lecture de cette cellule FRAM se fait de façon identique à celle d'une DRAM, dont le schéma électrique est représenté sur la figure 1A. Pour de telles cellules, la ligne de bit BL est polarisée pour l'écriture d'un "1" et n'est pas polarisée pour l'écriture d'un "0", le transistor T étant rendu passant, lors de la programmation de la cellule, par polarisation de la ligne d'écriture WL.

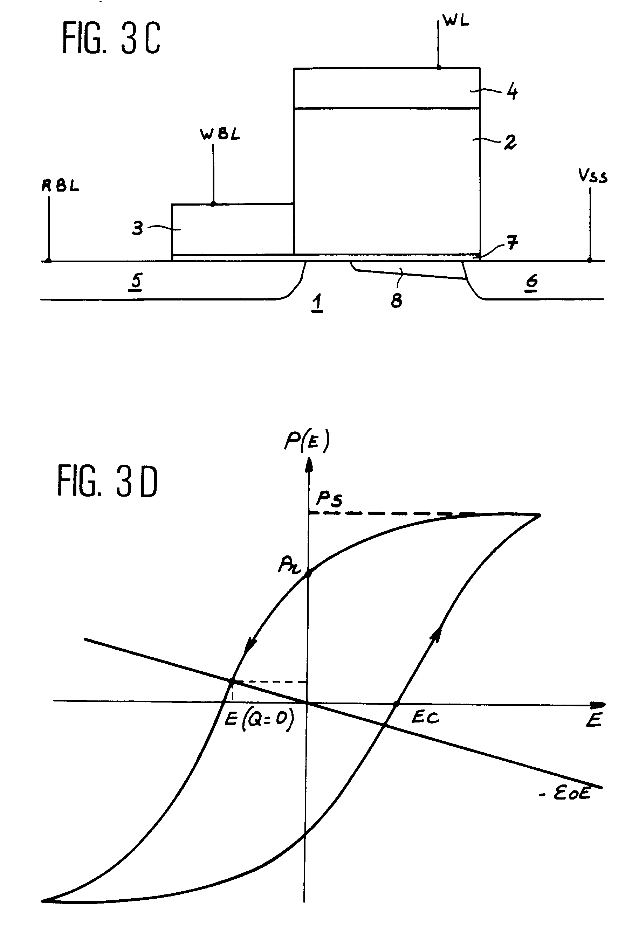

On rappelle qu'un matériau ferroélectrique a pour propriété de présenter un état de polarisation variant avec le champ électrique appliqué selon un cycle d'hystérésis, tel que représenté sur la figure 3D.

On en déduit les propriétés suivantes :

Il existe une polarisation rémanente P induisant une charge image Q sur les électrodes (Q = P) en l'absence de champ électrique. Cette polarisation rémanente dépend de l'historique des charges appliquées précédemment, si un fort champ électrique a été appliqué, champ qui dépasse une certaine valeur appelée "champ coercitif". La polarisation est positive, et respectivement négative si le champ électrique est négatif.

La charge déplacée au cours d'un échelon de tension de 0 à +V (ou à -V) va dépendre de l'état dans lequel est le ferroélectrique, à condition que V dépasse la valeur du champ coercitif. Par ailleurs, on peut avoir une charge image nulle, bien que le champ soit non nul,ceci en appliquant la loi de GAUSS, c'est-à-dire $E = \dfrac{Q - P(E)}{\varepsilon_o}$, et ensuite en posant Q = 0 dans le cas où E est tel que P(E) = - $\varepsilon_o$ E.

Dans la version la plus courante de mémoire utilisant un condensateur métal-ferroélectrique-métal, l'information est lue en soumettant le condensateur à un échelon de tension, tel que le champ coercitif soit dépassé. Selon l'état de polarisation initial, on va faire basculer, ou non, le ferroélectrique dans l'état de polarisation opposé.

La quantité de charge déplacée sera plus importante dans le cas du basculement. On va donc pouvoir lire l'état du point mémoire grâce à un circuit d'amplification de courant sur la ligne de bit (appelée aussi Bit Line) capable de discriminer la charge lue par rapport à un seuil prédéterminé. Il y a nécessité, du moins si le basculement a été constaté, de remettre le ferroélectrique dans son état initial par un nouvel échelon de tension de sens opposé.

L'inconvénient majeur de cette technologie est lié à l'effet de fatigue des matériaux ferroélectriques. La polarisation rémanente s'estompe peu à peu après un nombre plus ou moins grand de basculements. Ce nombre critique est typiquement de l'ordre de $10^9$ à $10^{11}$ cycles de basculement. On ne peut donc écrire et lire plus de $10^9$ fois un tel point mémoire. Il est important de remarquer ici qu'une telle mémoire est d'ores et déjà plus endurante à l'écriture qu'une mémoire EEPROM que l'on ne peut lire et programmer que $10^6$ fois.

De plus, ces mémoires sont beaucoup plus rapides à l'écriture. En effet, moins de 100 nanosecondes sont suffisantes pour inverser le sens de polarisation. Cependant, l'endurance à la lecture est beaucoup plus médiocre qu'une mémoire EEPROM. Pour simplifier, on peut dire que, par comparaison avec la mémoire EEPROM, une mémoire réalisée selon la technologie décrite est une mémoire essentiellement programmable ("Write mostly").

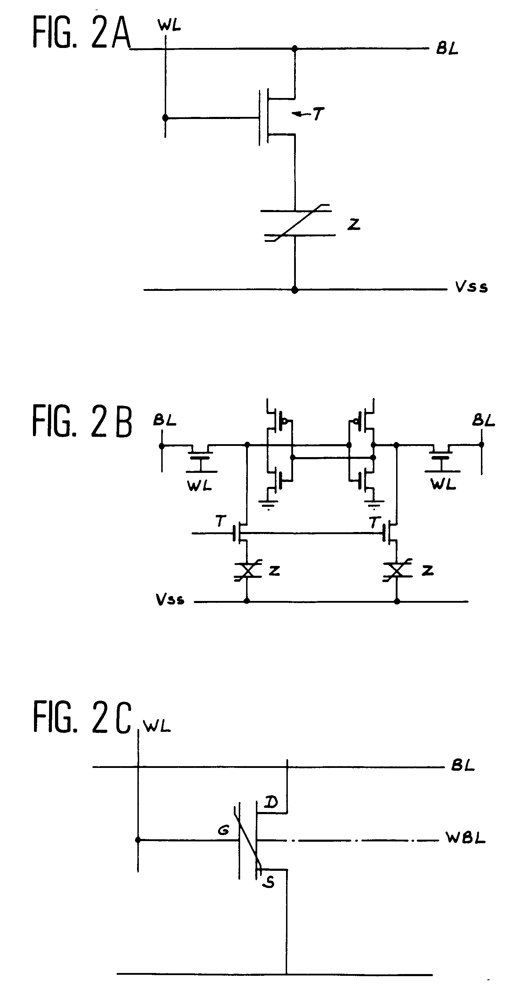

Pour pallier cet inconvénient, une autre variante de cellules utilisant également des condensateurs métal-ferroélectrique-métal a été proposée. Il s'agit des mémoires SRAM ferroélectriques représentées sur la figure 2B et décrites dans le document précédemment cité (article de la Revue Electronics) ainsi que dans la demande de brevet déposée le 2 juillet 1987 et publiée sous le numéro 4 809 225. Une telle mémoire fonctionne comme une mémoire SRAM conventionnelle à 6 (ou 4) transistors, telle que représentée sur la figure 1B, sans basculement des condensateurs ferroélectriques, lors des cycles d'écriture/lecture. Ces derniers sont sollicités uniquement en cas de coupure d'alimentation grâce à l'ouverture automatique de transistors rendus passant par cette coupure. Ce concept, certes astucieux, a malheureusement un inconvénient majeur qui est le coût élevé par point mémoire en raison du nombre de transistors et de surface de semi-conducteur par point mémoire.

D'autre part, la structure de mémoire la plus simple utilisant un seul transistor et un seul condensateur par point mémoire (cellule FRAM) nécessite un basculement quasi-systématique. Outre le problème de l'endurance, elle présente, de plus, un grave inconvénient car elle ne tolère pas les fluctuations, parfois importantes, des charges déplacées dans le ferroélectrique d'une cellule à l'autre ou sur une même cellule lors de son vieillissement. En effet, compte tenu de ces fluctuations, il peut devenir impossible de discriminer un état de polarisation d'un autre par lecture de la charge déplacée.

Il est connu, comme dans l'article de Shu-Yan WU de 1974, dans IEEE Transactions on electron devices, page 499, d'utiliser un transistor métal-ferroélectrique-semi-conducteur pour résoudre ces difficultés. Dans ce transistor, le ferroélectrique remplace le diélectrique moS conventionnel représenté sur la figure 2C), cette cellule fonctionnant de façon similaire à celle d'une EEPROM (figure 1C).

Le ferroélectrique est polarisé uniformément sur toute sa surface dans un état de polarisation rémanente prédéterminé (état 0). Dans cet état, le transistor, pour une tension de grille de lecture choisie, est dans un état passant. La programmation de l'état 1 complémentaire se fait par l'application de tensions appropriées aux bornes du ferroélectrique par la grille G, le drain D et si nécessaire le substrat, grâce à une prise substrat supplémentaire, tels qu'il y ait au moins localement inversion du sens de la polarisation rémanente du ferroélectrique. A l'aplomb de ces endroits dans le semi-conducteur, par effet de champ induit, les charges seront repoussées et le transistor aura été rendu non passant pour la tension de grille et de lecture.

La tension de programmation du côté semi-conducteur peut s'appliquer :

* sur le drain du transistor. On aura alors inversion de la polarisation uniquement à proximité du drain, mais cela suffira à bloquer le transistor. C'est la version la plus simple car on peut faire une programmation point par point sans prise de contact supplémentaire.

* sur le substrat, avec maintien des zones sources et drains à la tension nulle. On aura alors inversion du ferroélectrique sur l'ensemble de la zone du canal. Mais cela nécessite une prise de contact spécifique pour chaque transistor si l'on veut faire une programmation point par point.

L'effacement de l'état 1 se fera par l'opération inverse, c'est-à-dire par la création d'un champ électrique opposé à celui créé lors de la programmation et par le rétablissement de la polarisation rémanente initiale.

Une telle mémoire présente une très grande endurance à la lecture tout comme les EPROM et les EEPROM, tout en ayant, en plus, une rapidité et une endurance à la programmation très nettement améliorées par rapport à ces dernières.

Cette structure se heurte néanmoins à une difficulté majeure. Le ferroélectrique doit être en contact intime avec le semi-conducteur. En effet, le rapport entre les permittivités du ferroélectrique et les diélectriques courants qui peuvent se former à l'interface ferroélectrique/semiconducteur est tel que toute la chute de potentiel a lieu dans le diélectrique, même si les épaisseurs de celui-ci sont supérieures à 1/10e de l'épaisseur totale. Or, un ferroélectrique n'est généralement pas stable chimiquement avec les semiconducteurs courants, à savoir notamment avec le silicium. Il va donc réagir avec ce dernier pour former des composés intermédiaires où certains éléments vont diffuser de part et d'autre de l'interface, détruisant ainsi les caractéristiques de l'un ou l'autre des matériaux.

Par ailleurs, il a été montré, pour un certain nombre de ferroélectriques, qu'il y a une injection de charge du semi-conducteur dans le ferroélectrique avec piégeage de ces charges dans ce dernier. La hauteur de barrière entre le semi-conducteur et le ferroélectrique est souvent insuffisante pour limiter cette injection. Les charges piégées écrantent souvent la polarisation et l'effet de champ induit par cette dernière. Il faudrait donc introduire un matériau diélectrique à forte hauteur de barrière, mais alors on retombe à nouveau sur le problème de l'écrantage du champ électrique de programmation par ce dernier et l'application de tensions de programmation trop élevée.

D'autre part, les couches ferroélectriques utilisées seules ont des propriétés de claquage médiocres. Enfin, le ferroélectrique a une constante diélectrique apparente extrêmement élevée. Ceci conduit a des capacités de grille trop importantes et à des difficultés d'optimisation des transistors.

La présente invention permet justement de résoudre ces inconvénients. Elle propose, en effet, une cellule mémoire non volatile avec au moins un transistor métal-ferroélectrique-semi-conducteur comprenant une source, un drain et une grille, ladite grille étant isolée de la source et du drain par une couche ferroélectrique. Cette cellule mémoire de l'invention est caractérisée par le fait que le transistor comporte une électrode latérale de programmation qui est en contact avec une paroi verticale de la couche ferroélectrique du transistor et qui est isolée de la grille.

De façon avantageuse, cette électrode est métallique.

De plus, selon un mode de réalisation, l'électrode de programmation est une électrode indépendante des électrodes de source et de drain.

Selon un autre mode de réalisation de l'invention, l'électrode de programmation est commune à l'une des électrodes de source ou de drain.

Avantageusement, cette cellule mémoire comporte une couche diélectrique entre la couche ferroélectrique et la couche de semi-conducteur, la couche ferroélectrique étant, de façon avantageuse, du titanate zirconate de plomb ($Pb(ZrTi)O_3$).

Le procédé de réalisation d'une telle cellule mémoire consiste :
- à réaliser le ou les transistors du type métal-ferroélectrique-semi-conducteur ; et
- à déposer une couche conductrice sur des zones de sources ou de drains mises en contact avec les parois latérales de la couche ferroélectrique.

Ce procédé de réalisation consiste, de façon avantageuse, à graver la couche conductrice de façon à obtenir au moins un résidu conducteur en contact avec l'une des parois verticale de la couche ferroélectrique.

D'autres caractéristiques et avantages de l'invention apparaîtront au cours de la description qui va suivre, donnée à titre illustratif, mais nullement limitatif, en référence aux dessins dans lesquels :
- les figures 1A, 1B, 1C, déjà décrites, représentent les schémas électriques respectivement de la cellule DRAM, de la cellule SRAM et de la cellule EPROM (ou FLASH et EEPROM à grille flottante) ;
- les figures 2A, 2B, 2C, déjà décrites, représentent les schémas électroniques respectivement de la cellule mémoire FRAM à un transistor, de la cellule mémoire FRAM basée sur une cellule SRAM à six transistors et de la cellule mémoire avec transistors métal-ferroélectrique-semi-conducteur ;
- les figures 3A et 3B représentent des schémas de principe du transistor de la cellule mémoire selon l'invention, respectivement dans un état 0 non programmé et dans un état 1 programmé ;
- la figure 3C représente le schéma de principe du transistor de la cellule mémoire, selon un mode de réalisation de l'invention dans lequel l'électrode d'écriture de bit est indépendante de la ligne de lecture de bit ;
- la figure 3D, décrite précédemment dans la description, est une courbe de représentation de la variation type de la polarisation avec le champ dans un matériau ferroélectrique ; et
- la figure 4 représente le diagramme de programmation d'un point mémoire.

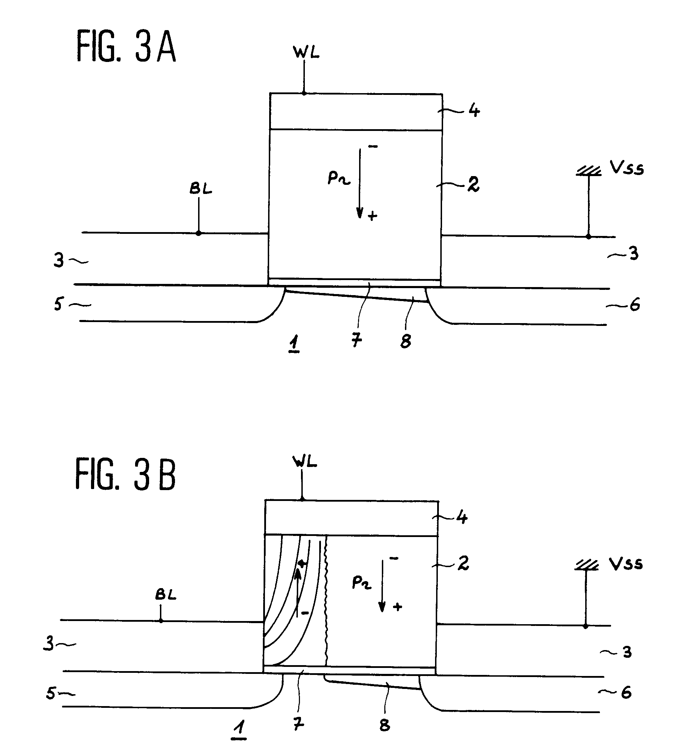

Sur les figures 3A et 3B, on a représenté le schéma de principe du transistor de la cellule mémoire selon l'invention.

Un point mémoire de type métal-ferroélectrique-semi-conducteur, tel que celui de l'invention, comprend un substrat semi-conducteur 1, une couche mince ferroélectrique 2 et une couche conductrice 3, placée de part et d'autre de la couche ferroélectrique 2.

Le substrat semi-conducteur peut être de type P ou de type N. Dans le dispositif décrit, on considère un substrat semi-conducteur 1 de type P.

La couche conductrice 3 est un matériau semi-conducteur dégénéré ou bien du métal.

Le point mémoire selon l'invention comporte de plus une électrode de grille 4, une zone de source 5, et une zone de drain 6. L'électrode de grille 4 réalise, avec le ferroélectrique 2, un motif de grille du transistor. La couche conductrice 3 est placée de part et d'autre de ce motif de grille. Elle est donc directement en contact avec le ferroélectrique 2, sur le flanc de celui-ci, ce qui signifie qu'il n'y a aucun matériau intermédiaire entre la couche conductrice 3 et le ferroélectrique 2.

Selon un mode de réalisation préféré de l'invention, la couche conductrice 3 recouvre les zones de source 5 et de drain 6 du semi-conducteur 1 constituant, avec elle, une seule et même électrode.

Selon un autre mode de réalisation de l'invention, la couche conductrice 3 peut être isolée desdites zones de source 5 et de drain 6 et constituer une électrode indépendante.

Comme dans la plupart des mémoires classiques, l'électrode de grille 4 est reliée à une ligne d'adressage appelée aussi ligne de mots ou encore "word line" (WL). De la même façon, la source 5 du transistor est reliée à une ligne de bit ou "bit line" (BL), et le drain 6 du transistor est relié à la masse ($V_{SS}$). La ligne de bit BL est à la fois la ligne d'écriture de bit et la ligne de lecture de bit.

Sur la figure 3C, on a représenté un mode de réalisation de l'invention, dans lequel la couche conductrice 3 est isolée des zones de source 5 et de drain 6. Cette couche conductrice 3 est alors reliée à une ligne d'adressage spécifique nommée ligne d'écriture de bit ou "write bit line" (WBL). Dans ce même cas de figure, la source 5 du transistor est reliée à une ligne de lecture, appelée ligne de lecture de bit ou "read bit line" (RBL).

Dans le mode de réalisation préféré de l'invention, représenté sur les figures 3A et 3B, c'est-à-dire dans le mode de réalisation où la couche conductrice est reliée électriquement aux source 5 et drain 6 du transistor, le pôle relié à la source sera relié à une seule et unique ligne servant à la fois de ligne d'adressage et de ligne de lecture, cette ligne étant la ligne de bit BL (ou bit line). Dans ce cas, le drain est relié à la masse $V_{SS}$.

De façon plus précise, la figure 3A montre un point mémoire à l'état 0.

La figure 3B montre au contraire un point mémoire de l'invention en son état 1, c'est-à-dire le point mémoire programmé. L'écriture de l'information dans ce point mémoire est réalisée d'une façon similaire à celle d'un transistor métal-ferroélectrique-semi-conducteur conventionnel, c'est-à-dire que l'écriture se fait en appliquant des tensions de programmation sur la grille et la couche conductrice 3 par l'intermédiaire respectivement de la Word line WL et de la ligne de bit BL. Les tensions de programmation sont telles que la valeur du champ électrique dans le ferroélectrique dépasse le champ coercitif et donc de façon à ce qu'il y ait une inversion de la polarisation rémanente à proximité du drain 6. Dans l'exemple décrit, les zones de source et de drain sont chargées positivement. En appliquant une tension négative sur BL et positive sur WL, cette polarisation, de sens opposé à celle de l'état O (figure 3A), permet de repousser les charges négatives du canal 8.

Cette inversion de polarisation a pour effet de rendre non passant le transistor par l'effet de champ produit, ce qui nécessite bien entendu de choisir convenablement les paramètres du transistor, à savoir le type et la valeur de dopage, la capacité de grille et la tension de grille à la lecture. Il faut également choisir les paramètres du matériau ferroélectrique, à savoir le champ coercitif, la polarisation rémanente après l'étape de polarisation. C'est cette rémanence de la polarisation qui permet de stocker l'information de façon non volatile.

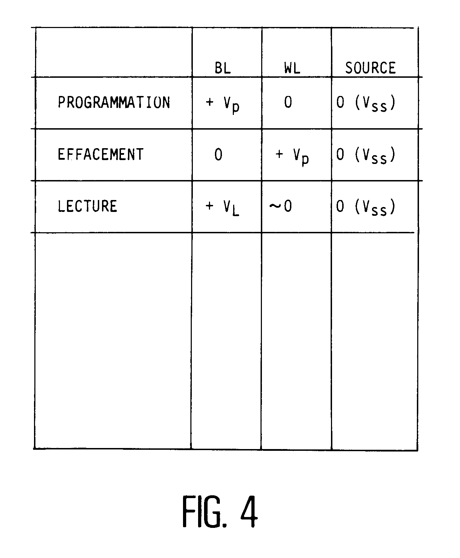

Le diagramme de programmation d'un tel point mémoire est donné sur le tableau de la figure 4, dans lequel la tension de programmation Vp est supérieure, en valeur absolue, au champ coercitif et la tension de lecture Vc est inférieure audit champ.

Selon un mode de réalisation préféré de l'invention, une couche diélectrique 7 est intercalée entre le ferroélectrique 2 et le semi-conducteur 1. Cette couche diélectrique 7 a un rôle de barrière. Elle est convenablement choisie de façon à ce que la structure soit chimiquement stable. En effet, cette couche diélectrique 7 est choisie de façon à ce que les deux interfaces réalisées entre le diélectrique et le semi-conducteur et entre le diélectrique et le ferroélectrique piègent un minimum de charges afin de ne pas écranter le champ électrique induit par le ferroélectrique 2.

Selon un exemple de réalisation du transistor de la cellule mémoire de l'invention, on considère un semi-conducteur 1 de type P de dopage de l'ordre de $10^{15}/cm^3$. La couche mince de ferroélectrique 2 est du PZT, c'est-à-dire du titanate zirconate de plomb de formule Pb(Zr, Ti) $O_3$, d'épaisseur appropriée.

Selon le mode de réalisation préféré de l'invention, la couche diélectrique 7 est réalisée en $S_iO_2$ et interposée entre le ferroélectrique 2 et le semi-conducteur 1. Cette couche diélectrique 7 a une épaisseur comprise entre quelques nanomètres et quelques dizaines de nanomètres. Au-dessus de cette couche diélectrique 7 et du ferroélectrique 2, un matériau conducteur est déposé pour constituer l'électrode de grille 4. L'ensemble de ces couches est gravé pour réaliser un motif de grille de transistor. Les zones de source et de drain, respectivement 5 et 6, sont réalisées de façon auto-alignée, par implantation ionique de dopants donneurs et recuits adéquats.

Les électrodes de source 5 et de drain 6 sont réalisées, de part et d'autre du motif de grille, à partir d'une technique de résidus en pied de motif. En effet, une couche conductrice 3 est déposée sur toute la surface puis gravée par une technique de gravure connue. Lorsque la gravure est réalisée, c'est-à-dire lorsque les surfaces planes sont dégagées, des résidus du matériau constituant la couche conductrice d'origine restent situés au pied des marches, c'est-à-dire que ces résidus constituent une sorte de monticule entre la couche ferroélectrique 2 et les électrodes de source 5 et de drain 6. Ces résidus de métal sont donc en contact direct avec le ferroélectrique 2, sur son flanc vertical, et avec le semi-conducteur 1 sur sa base, c'est-à-dire sur les zones de source 5 et de drain 6. Le métal constituant les résidus est choisi de façon à ce que le contact avec le ferroélectrique 2 ait un comportement électrique convenable. L'épaisseur du métal sur le flanc du ferroélectrique 2, est telle qu'elle puisse permettre une polarisation de signe voulu, suffisamment étendue pour couvrir, partiellement, la zone de canal. Cette épaisseur est de l'ordre de 100 nanomètres pour une couche de ferroélectrique d'environ 200 nanomètres.

Le procédé de réalisation d'un tel point mémoire consiste à réaliser le transistor de type métal-ferroélectrique-semi-conducteur de façon optimisée afin que la polarisation rémanente et le champ coercitif permettent un fonctionnement de la mémoire.

Les paramètres à considérer pour obtenir cette optimisation de la composition ferroélectrique du transistor, sont tout d'abord la différence de tension de seuil V0 - V1 entre les deux états 0 et 1. Cette différence de tension de seuil est donnée approximativement par l'expression :

$$2e_F E(Q = 0) = V0 - V1,$$

$e_F$ étant l'épaisseur du ferroélectrique 2, V0 et V1 étant les tensions appliquées à la grille correspondant à l'absence de charge (tension de bande plate) dans le semi-conducteur. Cette différence de tension V0 - V1 doit être suffisante, c'est-à-dire supérieure ou égale à quelques volts, de sorte que, pour une tension de grille de lecture $V_L$ comprise entre V0 et V1, les transconductances soient notablement différentes et permettent, ainsi, la lecture de l'état du point mémoire. En pratique, cette différence de tension V0 - V1 doit être de l'ordre de 5 volts.

Conformément au mode de réalisation préféré de l'invention, une couche diélectrique 7 est interposée entre le ferroélectrique 2 et le semi-conducteur 1. Cette couche diélectrique a une épaisseur typique d'environ 10 à 30 nanomètres. Cette couche diélectrique permet de rapprocher la valeur du champ électrique E (pour Q = 0) de la valeur EC du champ coercitif.

En effet, la variation de la polarisation avec le champ électrique E est très élevée dans un ferroélectrique. Pour un ferroélectrique standard, tel que le tritanate zirconate de plomb $Pb(Zr_{0,55}Ti_{0,45}O_3)$, EC est de l'ordre de 50 kv/cm et l'épaisseur pour obtenir une différence de tension de l'ordre de 5 volts (V0 - V1 5 volts) est donc $e_F$ = 5 100 nanomètres. Aussi, lors de la programmation de l'effacement du point mémoire, la différence de potentiel entre l'électrode de drain et l'électrode de grille (de 5 volts) appliquée à cette même épaisseur $e_F$ typique, le champ électrique moyen est de 100 kv/cm, ce qui est une valeur largement supérieure à la valeur du champ coercitif dont la valeur a été donnée précédememnt, valeur permettant d'inverser le sens de la polarisation, donc l'état du point mémoire.

La couche diélectrique permet justement de diminuer la capacité de grille $C_i = \dfrac{C_F C_D}{C_F + C_D}$ , $C_F$ étant la capacité du ferroélectrique et $C_D$ la capacité du diélectrique. L'épaisseur de la couche diélectrique est choisie de façon à optimiser les caractéristiques du transistor, à savoir sa tension de seuil moyenne $\dfrac{V0 + V1}{2}$ , sa tenue en tension et son courant a saturation. Pour une épaisseur du diélectrique $e_D$ supérieure ou égale à 20 nanomètres, la capacité de grille $C_i$ est à peu près égale à la capacité du diélectrique.

On comprendra que les valeurs citées en exemple sont données à titre totalement indicatif, étant entendu que le type du semi-conducteur et son dopage, le type et la composition du ferroélectrique pour faire changer le champ coercitif, l'épaisseur du ferroélectrique, la hauteur de l'électrode sur le flanc du ferroélectrique, l'épaisseur du diélectrique et les tensions de programmation et de lecture peuvent être modifiées conjointement tout en gardant les principes de fonctionnement décrits précédemment.

Le transistor métal-ferroélectrique-semi-conducteur de l'invention a pour avantage de permettre une prise de contact métallique pour la polarisation au moment de l'écriture, ce contact métal-ferroélectrique étant plus intime (absence d'oxyde natif, meilleure compatibilité métallurgique) et plus facile à réaliser.

De plus, ce transistor selon l'invention permet de réduire la tension nécessaire au basculement du ferroélectrique localement au moment de la programmation, la distance entre les deux électrodes d'écriture étant réduite (distance entre la grille et le contact pris sur le ferroélectrique).

En outre, dans un tel transistor, il est possible d'intercaler une couche diélectrique entre la couche ferroélectrique et le canal 8 du semi-conducteur (ce qui rend la réalisation pratique plus aisée) tout en permettant une tension de programmation faible puisque la tension est appliquée directement sur le ferroélectrique.

## Revendications

1. Cellule mémoire non volatile avec au moins un transistor métal-ferroélectrique-semi-conducteur comprenant une source (5), un drain (6) et une grille (4), ladite grille étant isolée de la source et du drain par une couche ferroélectrique (2), caractérisée en ce que le transistor comporte une électrode latérale de programmation (BL), ladite électrode étant en contact avec une paroi verticale de la couche ferroélectrique du transistor et isolée de la grille.

2. Cellule mémoire selon la revendication 1, caractérisée en ce que l'électrode de programmation est métallique.

3. Cellule mémoire selon la revendication 1 ou 2, caractérisée en ce que l'électrode de programmation est une électrode indépendante des électrodes de source et de drain.

4. Cellule mémoire selon la revendication 1 ou 2, caractérisée en ce que l'électrode de programHHHHmation est commune à l'une des électrodes de source ou de drain.

5. Cellule mémoire selon l'une quelconque des revendications 1 à 4, caractérisée en ce qu'elle comporte une couche diélectrique (7) entre la couche ferro-électrique et la couche de semi-conducteur (1).

6. Cellule mémoire selon l'une quelconque des revendications 1 à 5, caractérisée en ce que la couche ferroélectrique est du titanate zirconate de plomb, $Pb(Zr, Ti)O_3$.

7. Procédé de réalisation d'une cellule mémoire selon la revendication 1, caractérisée en ce qu'il consiste :
    - à réaliser le ou les transistors de type métal-ferroélectrique-semi-conducteur ; et
    - à déposer une couche conductrice sur des zones de source ou de drain mises en contact avec les parois latérales de la couche ferroélectrique.

8. Procédé de réalisation d'une cellule mémoire selon la revendication 7, caractérisé en ce qu'il consiste, en outre, à graver la couche conductrice de façon à obtenir au moins un résidu conducteur en contact avec l'une des parois verticales de la couche ferroélectrique.

# FIG. 1A

# FIG. 1B

# FIG. 1C

FIG. 2A

FIG. 2B

FIG. 2C

# FIG. 3 A

# FIG. 3 B

## FIG. 3 C

## FIG. 3 D

|  | BL | WL | SOURCE |
|---|---|---|---|
| PROGRAMMATION | + $V_p$ | 0 | 0 ($V_{ss}$) |
| EFFACEMENT | 0 | + $V_p$ | 0 ($V_{ss}$) |
| LECTURE | + $V_L$ | ~0 | 0 ($V_{ss}$) |
|  |  |  |  |

FIG. 4

Office européen
des brevets

**RAPPORT DE RECHERCHE EUROPEENNE**

Numero de la demande

EP    93 40 0486

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-2 791 759 (BROWN)<br>* le document en entier * | 1-3 | G11C11/22<br>G11C27/00 |
| A | US-A-4 888 630 (PATERSON)<br>* colonne 4, ligne 58 - colonne 6, ligne 62; figures 3,4 * | 1 | |
| A | FR-A-2 323 228 (WESTINGHOUSE ELECTRIC CORPORATION)<br>* page 4, ligne 29 - page 11, ligne 41; figures 1-4 * | 1,5,6,7 | |
| A | US-A-3 832 700 (WU E.A.)<br>* le document en entier * | 1 | |
| A | PROCEEDINGS OF THE IEEE<br>vol. 54, no. 6, Juin 1966,<br>pages 842 - 848<br>HEYMAN E.A. 'A FERROELECTRIC FIELD EFFECT DEVICE'<br>* page 847, colonne 2, alinéa 5 - page 848, colonne 1, ligne 18 * | 1 | **DOMAINES TECHNIQUES RECHERCHES (Int. Cl.5)**<br><br>G11C<br>H01L |

Le présent rapport a été établi pour toutes les revendications

| Lieu de la recherche | Date d'achèvement de la recherche | Examinateur |
|---|---|---|
| LA HAYE | 21 MAI 1993 | DEGRAEVE L.W.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
....................................................................
& : membre de la même famille, document correspondant

EPO FORM 1503 03.82 (P0402)